Europäisches Patentamt

European Patent Office

Office européen des brevets

(11) Numéro de publication: **0 358 144 B1**

(12) **FASCICULE DE BREVET EUROPEEN**

(45) Date de publication de fascicule du brevet: **01.09.93** (51) Int. Cl.⁵: **H01S 3/103**, H01S 3/098

(21) Numéro de dépôt: **89116283.6**

(22) Date de dépôt: **04.09.89**

(54) Source laser à semi-conducteur modulée à fréquence élevée.

(30) Priorité: **08.09.88 FR 8811741**

(43) Date de publication de la demande:
**14.03.90 Bulletin 90/11**

(45) Mention de la délivrance du brevet:
**01.09.93 Bulletin 93/35**

(84) Etats contractants désignés:
**AT BE CH DE ES FR GB IT LI NL SE**

(56) Documents cités:
**EP-A- 0 189 252**

**APPLIED PHYSICS LETTERS, vol. 46, no. 12, 15 juin 1985, pages 1117-1119, American Institute of Physics, New York, US; K.Y. LAU et al.: "Passive and active mode locking of a semiconductor laser without an external cavity"**

**IEEE JOURNAL OF OUANTUM ELECTRONICS, vol. OE-19, no. 2, février 1983, pages 164-168, IEEE, New York, US; J.P. VAN DER ZIEL et al.: "Dispersion of the group velocity refractive index in GaAs double heterostructure lasers"**

(73) Titulaire: **ALCATEL N.V.**
**Strawinskylaan 537 (World Trade Center)**
**NL-1077 XX Amsterdam(NL)**

(72) Inventeur: **Chesnoy, José**
**22 rue Emile Dubois**
**F-75014 Paris(FR)**

(74) Mandataire: **Weinmiller, Jürgen et al**
**Lennéstrasse 9 Postfach 24**
**D-82336 Feldafing (DE)**

IEEE JOURNAL OF OUANTUM ELECTRONICS, vol. OE-23, no. 6, juin 1987, pages 835-838, IEEE, New York, US; S. MURATA et al.: "Spectral characteristics for a 1.5 mum DBR laser with frequency-tuning region"

ELECTRONICS LETTERS, vol. 23, no. 7, 26 mars 1987, pages 325-327, IEE, Hitchin, GB; Y. KOTAKI et al.: "1.55 mum wavelength tunable FBH-DBR laser"

JOURNAL OF LIGHTWAVE TECHNOLOGY, vol. LT-5, no. 4, avril 1987, pages 516-522, IEEE, New York, US; Y. YOSHIKUNI et al.: "Multielectrode distributed feedback laser for pure frequency modulation and chirping suppressed amplitude modulation"

OPTICS LETTERS, vol. 12, no. 5, mai 1987, pages 334-336, Optical Society of America, New York, US; J. KUHL et al.: "Bandwidth-limited picosecond pulse generation in an actively mode-locked GaAs laser with intracavity chrip compensation"

JOURNAL OF APPLIED PHYSICS, vol. 52, no. 7, juillet 1981, pages 4457-4461, American Institute of Physics, New York, US; C.H. HENRY et al.: "Spectral dependence of the change in refractive index due to carrier injection in GaAs lasers"

JAPANESE JOURNAL OF APPLIED PHYSICS, vol. 20, no. 6, juin 1981, pages 1007-1020, Tokyo, JP; H.A. HAUS: "Modelocking of semiconductor laser diodes"

## Description

La présente invention concerne l'obtention d'une onde lumineuse modulée à fréquence élevée. Diverses sources sont connues dans ce but et les éléments essentiels de l'une d'entre elles vont d'abord être indiqués. Certains de ces éléments sont communs, au moins partiellement, à cette source connue et à une source selon la présente invention. Ces éléments communs sont :

- une plaquette monolithique ayant deux faces extrêmes opposées, cette plaquette étant constituée d'un matériau semi-conducteur à dopage différencié dont l'indice de réfraction est localement diminué pour guider des ondes lumineuse sur la longueur d'un canal de lumière s'étendant de l'une à l'autre des deux dites faces extrêmes,
- un moyen d'injection d'amplification pour injecter dans ladite plaquette un courant de polarisation unidirectionnel ($I_p$) réalisant une inversion de population dans ledit canal de lumière de manière à y amplifier desdites ondes lumineuses, le gain représentatif de l'amplification éventuelle d'une onde n'étant positif que si la fréquence de cette onde est située dans un domaine spectral de gain qui présente une largeur spectrale de gain,
- deux réflecteurs pour constituer entre eux une cavité optique incluant ledit canal de lumière et présentant une longueur optique de cavité L, de sorte que cette cavité est résonnante selon une succession de modes pour des ondes lumineuses présentant une succession correspondante de fréquences propres, ces fréquences étant séparées par des intervalles égaux à une fréquence inter-mode

$$f_i = c/2L,$$

c étant la vitesse de la lumière, de manière que cette cavité constitue un oscillateur laser pouvant produire des ondes lumineuses à des fréquences proches de celles desdites fréquences propres qui sont situées dans ledit domaine spectral de gain, et qu'un couplage de modes soit possible entre les ondes produites,

- et un moyen d'injection de modulation (CM) pour injecter dans ladite plaquette un courant de modulation alternatif ($I_{HF}$) présentant une fréquence de modulation ($f_m$) et traversant lui aussi ledit canal de lumière pour y faire apparaître une composante de gain alternative, cette fréquence de modulation étant proche de ladite fréquence intermode pour y imposer un dit couplage de modes grâce auquel ledit oscillateur produit lesdites ondes lumineuses sous la forme d'une onde porteuse modulée (OP), au moins une composante de modulation de cette onde constituant un signal de modulation de sortie présentant ladite fréquence de modulation.

Cette première source connue a été décrite dans un article (J.P. van der ZIEL, Semiconductors and Semimetals, vol. 22, B, p. 1, 1985, Academic Press). Sa cavité optique est essentiellement extérieure à la plaquette semi-conductrice. Elle fournit des impulsions lumineuses de faible durée (de l'ordre de quelques picosecondes) à une cadence de répétition qui est typiquement de 100 MHz et a pu atteindre 9,4 GHz. Dans le cas des cadences supérieures à 1 GHz environ la cohérence de l'onde porteuse obtenue est mauvaise ce qui limite d'ailleurs la cadence maximale aux environs de 10 Ghz. Dans le cas des cadences plus basses l'onde porteuse modulée ne transporte qu'une faible puissance dans chacune des nombreuses raies spectrales de modulation qu'elle comporte.

D'autres possibilités sont connues pour constituer une source laser à semi-conducteur modulée à fréquence élevée.

Une possibilité est offerte par la modulation directe du laser : La puissance du courant de modulation est choisie suffisante pour assurer par elle-même la modulation souhaitée de l'onde lumineuse, sans l'aide du phénomène de couplage de modes. En plus d'autres inconvénients, les fréquences accessibles à l'aide d'une source ainsi constituée sont limitées par la fréquence des oscillations de relaxation, c'est-à-dire à environ 10 GHz pour les lasers à semi-conducteurs actuels et vraisemblablement à un maximum de 20 GHz à l'avenir (G.P. AGRAWAL and N.K. DUTTA, Long wavelength semiconductor lasers, Van Nostrand, 1986).

Une autre possibilité est offerte par les odulateurs externes pour lesquels les bandes passantes atteignent actuellement 40 GHz (K. UHDE, Electronic letters n° 23, p. 1156, 1987).

Un autre possibilité connue consiste à faire battre deux lasers de fréquences différentes ou deux modes d'un même laser. Cette possibilité a été appliquée à des lasers à semi-conducteurs par injection de lasers "esclaves" par un laser "maître" modulé (L. GOLDBERG, A.M. YUREK, J.F. WELLER and H.F. TAYLOR, Electronic Letters n° 21, p.814, 1985). Mais sa mise en oeuvre est délicate et ne permet pas d'envisager facilement des possibilités d'intégration.

Une telle intégration apparait cependant souhaitable sous la forme d'un oscillateur laser monolithique quand la source à réaliser doit constituer un composant d'un système (de télécommunication par exemple).

C'est pourquoi un couplage de modes d'un laser à semi-conducteurs monolithique à cavité courte par injection de courant a été réalisé (K.Y. LAU, I. URY and A. YARIV, Appl. Phys. Lett. n° 46, p. 1117, 1985). Mais il ne l'a été que partiellement et le composant ainsi constitué ne permettait pas de définir la phase du signal de modulation de sortie, ni d'obtenir une émission optique très cohérente pour constituer l'onde porteuse. Les auteurs ont utilisé des courants de modulation très importants sans réaliser pour autant un couplage de modes complet. Il en résulte que ce composant n'a pas été considéré comme permettant de constituer une source optique modulable.

Une dernière possibilité connue est donnée par la génération d'impulsions lumineuses picosecondes qui occupent un large domaine de fréquences en raison de la faible durée des impulsions. Ces impulsions peuvent être obtenues par commutation du gain (K.Y. LAU and A. YARIV, Semiconductors and Semimetals, vol. 22, B, p. 69, 1985, Academic Press) ou par couplage des modes longitudinaux d'une cavité externe, comme réalisé dans ladite première source connue. Dans les deux cas, comme précédemment indiqué, la cadence de répétition des impulsions étant faible, l'énergie transportée dans une bande de fréquences étroite est elle aussi faible.

La présente invention a notamment les buts suivants concernant la modulation d'une onde porteuse optique :
- Elever la fréquence de modulation, dans le domaine de hyperfréquences ;
- Réaliser une modulation transportant une proportion majoritaire de sa puissance dans une bande très étroite, c'est-à-dire sous la forme d'une onde fondamentale éventuellement elle-même modulée, mais à fréquence beaucoup plus basse, les harmoniques de cette onde fondamentale ne transportant qu'une proportion petite, inférieure de préférence à 20 % de la puissance ;
- Diminuer le courant de modulation, de préférence bien au-dessous de 50 % du courant de polarisation ;
- Lorsque les deux buts précédents ne sont pas utiles, et lorsqu'un courant de modulation important peut être utilisé, réaliser, une modulation sous la forme d'impulsions se succédant à une cadence accrue ;
- Moduler le signal de modulation de sortie lui-même en amplitude et/ou phase et/ou fréquence ;
- Réaliser la modulation à l'aide d'une source monolithique et compacte.

Une source laser selon la présente invention comporte de manière monolithique, entre deux réflecteurs, une section de modulation couplée à une section guide avec un filtrage additionnel, et elle est pilotée par un courant de polarisation continu et par un courant de modulation hyperfréquence de plus faible amplitude.

Cette invention a plus particulièrement pour objet une source comportant les éléments communs précédemment mentionnés, cette source étant caractérisée, par rapport à la première source connue précédemment mentionnée, par le fait que ladite plaquette porte lesdits réflecteurs sur ses dites faces extrêmes de manière que ladite longueur optique de cavité L soit limitée par la longueur dudit canal de lumière pour situer ladite fréquence intermode ($f_i$) et par conséquent aussi ladite fréquence de modulation ($f_m$) dans le domaine des hyperfréquences, ledit signal de modulation constituant un signal hyperfréquence de sortie (SHF),
- cette plaquette comportant en outre un moyen de limitation de dispersion disposé dans ladite cavité optique pour limiter la dispersion des temps de propagation de groupe desdites ondes lumineuses dans cette cavité,
- et un filtre additionel inclus dans ladite cavité optique pour que ledit oscillateur laser ne puisse produire lesdites ondes lumineuses qu'à l'intérieur d'un domaine spectral de filtrage présentant une largeur de filtrage inférieure à la moitié de ladite largeur spectrale de gain, tout en étant supérieure à ladite fréquence intermode, de manière à éviter des instabilités des fréquences desdites ondes produites par ledit oscillateur laser,
- et ladite modulation de gain étant réalisée seulement dans une section de la longueur dudit canal de lumière, cette section étant une section de modulation de gain et s'étendant sur une fraction minoritaire de cette longueur à une extrémité de celle-ci, de manière à imposer une phase prédéterminée audit signal hyperfréquence de sortie par rapport audit courant de modulation.

On peut adopter de plus les dispositions suivantes qui sont préférées dans certains cas :

Ledite moyen d'injection d'amplification limite ladite inversion de population et ladite amplification des ondes lumineuses à une section de gain dudit canal de lumière, cette section constituant en même temps ladite section de modulation de gain et sa longueur optique occupant une fraction inférieure au quart de ladite longueur optique de cavité (L). Le reste de la longueur de la cavité peut alors constituer une section guide passive dans laquelle le matériau interne du canal de guidage est intrinsèquement transparent. On peut noter cependant qu'une telle section guide passive pourrait être remplacée par une section guide neutre dans laquelle ce matériau ne serait pas intrinsèquement transparent et serait interposé entre des couches semi-conductrices de types de conductivité opposés de manière à permettre un gain mais qui serait traversée par un courant choisi pour lui donner en fait un gain nul.

Ladite largeur de filtrage est comprise entre 2 fois et 100 fois ladite fréquence intermode ($f_i$) de manière que ledit couplage de modes se réalise sur plusieurs modes longitudinaux.

Ledit filtre additionnel est un réflecteur de Bragg distribué occupant une section de filtrage à une extrémité de ladite cavité optique. Un tel réflecteur est connu internationalement, sous le sigle DBR correspondant à "Distributed Bragg Reflector". Il permet de rétrécir la largeur du filtrage à une valeur de l'ordre du nanomètre, afin d'obtenir un composant de grande dynamique (c'est-à-dire permettant de réaliser de grandes variations de la puissance optique modulée). La largeur spectrale du filtre DBR doit néanmoins rester assez large par rapport à $f_m$ pour ne pas nécessiter un courant $I_{HF}$ trop important (ce qui nécessite d'obtenir de forts coefficients de couplage K de l'ordre de 100 ou 200 cm$^{-1}$). Quoique cela ne semble pas préférable, ce filtre pourrait être constitué autrement, notamment par un empilement de couches diélectriques constituant un dit réflecteur à une extrémité de ladite cavité optique.

Ledit domaine spectral de filtrage est choisi pour coincider avec un domaine de fréquences dans lequel un paramètre de dispersion présente une valeur négative dans ladite section de gain alors qu'il présente une valeur positive dans une autre partie dudit canal de guidage, cette valeur négative étant supérieure en valeur absolue à trois fois cette valeur positive, ce paramètre étant la dérivée seconde ($d^2n/d$ lambda$^2$) de l'indice de réfraction (n) dans ledit canal de guidage par rapport à la longueur d'onde (lambda) desdites ondes lumineuses, de manière que l'association de cette section de gain et de ladite autre partie du canal de guidage réalise une compensation de dispersion pour constituer ledit moyen de limitation de dispersion. Cependant, de manière plus générale, ladite compensation peut être réalisée par le fait que la longueur de ladite cavité comporte des sections présentant des valeurs de dispersion de signes opposés, ces valeurs étant représentatives de la dispersion de la vitesse de propagation de groupe desdites ondes lumineuses dans ces sections, respectivement.

De préférence enfin l'un au moins des deux dits réflecteurs est semi transparent pour laisser sortir une onde de sortie constituée par ladite onde porteuse (OP) modulée par ledit signal hyperfréquence de sortie (SHF).

Les dispositions ci-dessus permettent de réaliser une source laser qui est modulée dans le domaine des hyperfréquences par couplage des modes d'une cavité de longueur millimétrique, et dans laquelle les différents paramètres de fonctionnement sont découplés par la construction de la cavité résonante sous la forme de sections successives. Par rapport aux sources connues, les fréquences de modulation ne sont plus limitées par les oscillations de relaxation contrairement au cas de la modulation directe, et l'énergie de modulation de sortie est essentiellement transportée à la fréquence de modulation contrairement au cas où l'onde de sortie est constituée par la succession d'impulsions brèves à basse cadence.

Une telle source est particulièrement apte à constituer un composant d'un système de télécommunication.

Et on va maintenant préciser les conditions du fonctionnement d'un tel composant. Comme précédemment exposé, la base de ce fonctionnement est le couplage des modes longitudinaux (G.H.C. NEW, Rep. Prog. Phys. n° 46, p. 877, 1983) d'une source laser à semi-conducteur à cavité résonante étendue, ce couplage étant obtenu par modulation du gain à une fréquence $f_m$ proche de la fréquence intermode propre à cette cavité. La modulation du gain est obtenue par injection d'un courant sinusoïdal $I_{HF}$ à la fréquence $f_m$, superposé à un courant de polarisation $I_p$ continu plaçant le laser au-dessus du seuil d'oscillation. La fréquence $f_m$ est donnée par le temps d'aller et retour de la lumière sur la longueur optique L de la cavité étendue :

$$1/f_m = 2L/c$$

où c est la vitesse de la lumière dans le vide et où la longueur L prend en compte l'indice de groupe de chacune des sections de la cavité étendue. Pour un indice moyen n = 4, une fréquence $f_m$ de 20 GHz est obtenue avec une cavité de longueur L voisine de 1,9 mm et une fréquence de 100 GHz avec une longueur L voisine de 0,37 mm.

L'émission optique de ce composant est constituée d'un faisceau lumineux modulé en intensité à la fréquence $f_m$. La puissance moyenne dépend approximativement linéairement du courant de polarisation $I_p$ et est voisine de celle qui serait obtenue en l'absence du courant de modulation.

Le taux de modulation (composante de puissance à la fréquence $f_m$, cette composante étant rapportée à la puissance totale moyenne) dépend approximativement linéairement du courant de modulation $I_{HF}$. Une modulation sinusoïdale à la fréquence $f_m$ est obtenue par le couplage de quelques modes de la cavité laser. Dans ce type de fonctionnement, la modulation d'intensité est due à la superposition de l'émission du laser sur plusieurs modes et peut avoir lieu à des fréquences très supérieures à la fréquence des oscillations de relaxation, ces fréquences étant limitées seulement par la largeur de gain et l'efficacité de la modulation du gain (soit un maximum envisageable aux environs de $f_m$ = 100 GHz). La modulation optique (c'est-à-dire celle de ladite onde porteuse) est formée au cours d'un grand nombre d'allers et retours de la lumière dans le composant (100 à 1000 typiquement). Ceci entraîne une bonne cohérence spectrale de l'émission optique, (c'est-à-dire de ladite onde porteuse), cette cohérence étant voisine de celle qui serait obtenue pour le fonctionnement monofréquence du même composant laser (D.W. RUSH, G.L. BURDGE and P.T. HO, IEEE J. Quant. Elec. Q.E. 22, p. 2088, 1986).

Les points importants pour le bon fonctionnement de ce composant sont indiqués ci-après. Pour sa réalisation et son utilisation une aide peut cependant être apportée par certains résultats qui ont été précédemment obtenus expérimentalement et théoriquement et qui concernent le couplage de modes dans une source laser par injection de courant dans un laser à semi-conducteur placé dans une cavité externe (H.A. HAUS, Jpn J. Appl. Phys. n° 20, p. 1007, 1981).

La section de modulation de gain doit être formée à une extrémité du composant afin de fixer la phase de la modulation d'intensité lumineuse par rapport à celle du courant de modulation $I_{HF}$. Elle doit être de faible longueur par rapport à la longueur optique totale de la cavité résonante laser, afin que la modulation de gain imposée par ce courant soit limitée à une fraction temporelle précise de l'intensité lumineuse circulant dans cette cavité. Par ailleurs la faible longueur de la section de gain qui coïncide avec cette section de modulation de gain limite aussi un effet défavorable connu qui est une destabilisation spectrale du gain. Cet effet est du à des appauvrissements locaux en états quantiques excités propres à amplifier lesdites ondes lumineuses. Ces appauvrissements sont localisés aux ventres de l'onde optique stationnaire oscillant dans la cavité résonante et sont connus sous l'appelation internationale "spatial hole burning".

La cavité doit être étendue par une section guide afin de déterminer par sa longueur la fréquence de modulation $f_m$. Il est important que le couplage optique entre sections successives ne soit pas perturbé par des rétroréflexions parasites. On choisit donc des structures permettant une bonne adaptation d'impédance optique avec des rétroréflexions limitées à un ou quelques pourcent au maximum.

La largeur spectrale optique permise par la cavité (cette largeur étant celle qui contient toutes lesdites fréquences permises et étant donnée par la courbe de gain et par le filtrage additionnel) doit être supérieure (en fréquences) à $f_m$, largeur limite

de l'onde lumineuse émise. Le courant $I_{HF}$ nécessaire pour obtenir une modulation donnée pour une cavité donnée est inversement proportionnel à cette largeur spectrale. On obtient donc une plus grande sensibilité de la commande de modulation en augmentant la largeur spectrale permise par la cavité. Néanmoins, une trop grande largeur spectrale permise amène une destabilisation de l'émission optique principalement à cause de la saturation du gain (spectrale, spatiale et temporelle). Ainsi, la largeur naturelle du gain des sources lasers à semi-conducteurs actuellement disponibles ne permet pas d'obtenir une émission de bonne cohérence dans les conditions indiquées ci-dessus. Un filtrage additionnel limité permet d'obtenir un composant sensible (commandé par un courant $I_{HF}$ de l'ordre du milliampère), mais fragile vis-à-vis des changements de conditions extérieures et donc de faible dynamique. Un filtrage étroit (quelques fois $f_m$) donne un composant moins sensible ($I_{HF}$ nécessaire de l'ordre de la dizaine de milliampères), mais plus robuste face aux perturbations extérieures et donc de grande dynamique de fonctionnement. On peut obtenir le filtrage par dépôt d'un filtre multidiélectrique sur l'une des faces du composant. Mais ce type de filtre semble trop peu sélectif. Un filtrage plus sélectif est obtenu en complétant le guide par un réflecteur de Bragg à réseau distribué DBR. Il convient d'avoir, là encore, une bonne adaptation optique avec le reste de la section guide et aussi de tenir compte du réseau de ce réflecteur DBR dans le calcul de la longueur optique de la cavité résonante.

Un paramètre important, déterminant l'efficacité de la modulation par le courant $I_{HF}$, est la dispersion des temps de propagation de groupe à l'intérieur du composant. La valeur de cette dispersion pourrait être calculée par l'intégration dudit paramètre de dispersion sur la longueur géométrique de la cavité. Les valeurs typiques de la dispersion dans les semi-conducteurs diminuent de façon considérable l'efficacité de la modulation lumineuse par rapport à ce que permettrait une dispersion nulle. Si l'on veut avoir la possibilité de piloter le composant par un courant $I_{HF}$ faible (quelques milliamères), il convient d'ajuster la dispersion des temps de propagation de groupe à une valeur proche de zéro. Cette possibilité est offerte par la présence sur le flanc haute fréquence de la courbe de gain (gain en fonction de la fréquence) d'une plage de dispersion "anormale" élevée, où ledit paramètre est négatif, ( J.P. van der ZIEL and R.A. LOGAN, IEEE J. Quant. Elec, QE 19, p 164, 1983). La valeur absolue de cette dispersion "anormale" est suffisante pour compenser la dispersion "normale" des autres sections pour lesquelles ce même paramètre est positif, à condition bien entendu que les longueurs relatives des différentes sections soient correctement ajustées. Il convient, pour obtenir cette compensation, de placer la plage de fréquences du filtre additionnel autant que possible dans la plage de dispersion anormale. Cette position spectrale du filtre sur le flanc haute fréquence de la courbe de gain améliore aussi l'efficacité de la modulation par augmentation du gain différentiel (C.H. HENRY, R.A. LOGAN and K.A. BERTNESS, J. Appl Phys. n° 52, p. 4457, 1981).

Une modulation d'amplitude de l'émission optique est possible par commande du courant de polarisation.

Un désaccord de la longueur optique est tolérable s'il ne dépasse pas une valeur relative de $10^{-2}$ ou $10^{-3}$ (comme dans le cas des lasers à cavité externe : J.C. GOODWIN and B.K. GARSIDE, IEEE J. Quant. Elec. QE 19, p.1068, 1983). Ce désaccord de fréquence amène un déphasage du signal hyperfréquence de sortie par rapport au courant de modulation et donne une possibilité de modulation de phase de ce signal.

Les bandes passantes des modulations d'amplitude ou de phase hyperfréquence sont limitées par le temps de construction du couplage de modes à $10^{-2}$ ou $10^{-3}$ $f_m$. Elles sont approximativement proportionnelles à $I_{HF}$. Elles valent au maximum quelques centaines de mégahertz.

La conversion d'énergie électronique en énergie optique est améliorée par une adaptation d'impédance électrique du courant de modulation $I_{HF}$ (il suffit de réaliser cette adaptation en bande étroite).

La structure semi-conductrice de la source selon l'invention peut être du même type que celles qui ont été décrites pour réaliser des lasers monomodes accordables (L.A. COLDREN and S.W. SCOTT, IEEE J. Quant. Elec. QE 23, p.903, 1987). Les propriétés électriques et optiques des sources lasers à semi-conducteurs connues étant voisines, le choix du matériau constitutif peut se faire en fonction de la longueur d'onde optique recherchée et la mise en oeuvre du couplage de modes sur des lasers constitués de GaAs ou d'InP, par exemple, est possible.

On peut par ailleurs noter qu'une compensation de dispersion a déjà été décrite, mais dans des lasers à cavité externe et donc pour des fréquences de modulation très éloignées de celles qui sont considérées ici (J. KUHL, M. SERENYI, E.O. GOBEL, Optics Letters, 12, p. 334 - 1987). Les moyens utilisés étaient de plus très différents.

Le composant constitué comme indiqué ci-dessus peut être modulé par action sur différentes grandeurs commandables : le courant de polarisation $I_p$, le courant de modulation $I_{HF}$, et éventuellement des signaux agissant sur la longueur de cavité L et sur la fréquence centrale du filtre additionnel. Divers dispositifs peuvent être réalisés par association à d'autres éléments tels qu'un détecteur optique ou une fibre optique.

Un avantage de ce composant est d'être commandable en amplitude et en phase par des courants modulables à une fréquence beaucoup plus basse que celle du signal hyperfréquence de sortie obtenu, le courant $I_{HF}$ restant de préférence constant. Une autre particularité de ce composant est de constituer une source à une haute fréquence, mais à bande spectrale étroite.

Dans certains cas il peut être cependant avantageux d'utiliser ce composant d'une manière différente. Le courant de modulation ($I_{HF}$) est alors choisi suffisamment grand pour faire apparaître dans ladite onde de sortie des composantes de modulation constituant des harmoniques présentant des fréquences multiples de ladite fréquence de modulation ($f_m$) de manière à constituer une source d'impulsions lumineuses à haute cadence de répétition.

A l'aide des figures schématiques ci-jointes on va décrire plus particulièrement ci-après, à titre d'exemple non limitatif, comment la présente invention peut être mise en oeuvre dans le cadre de l'exposé qui en a été donné ci-dessus. Lorsqu'un même élément est représenté sur plusieurs figures il y est désigné par le même signe de référence. Les modes de mise en oeuvre décrits comportent les dispositions mentionnées ci-dessus comme préférées selon la présente invention. Il doit être compris que les éléments mentionnés peuvent être remplacés par d'autres éléments assurant les mêmes fonctions techniques.

La figure 1 représente une vue de côté d'une source selon la présente invention.

La figure 2 représente une vue de cette source en coupe transversale.

La figure 3 représente un diagramme temporel d'une onde de sortie émise par cette source.

Les figures 4, 7 et 10 représentent des courants de commande appliqués à cette source pour diverses applications de celle-ci.

Les figures 5, 8, 11 et 13 représentent cette source dans ces diverses applications.

Les figures 6, 9, 12 et 14 représentent des ondes ou signaux de sortie de cette source dans ces diverses applications.

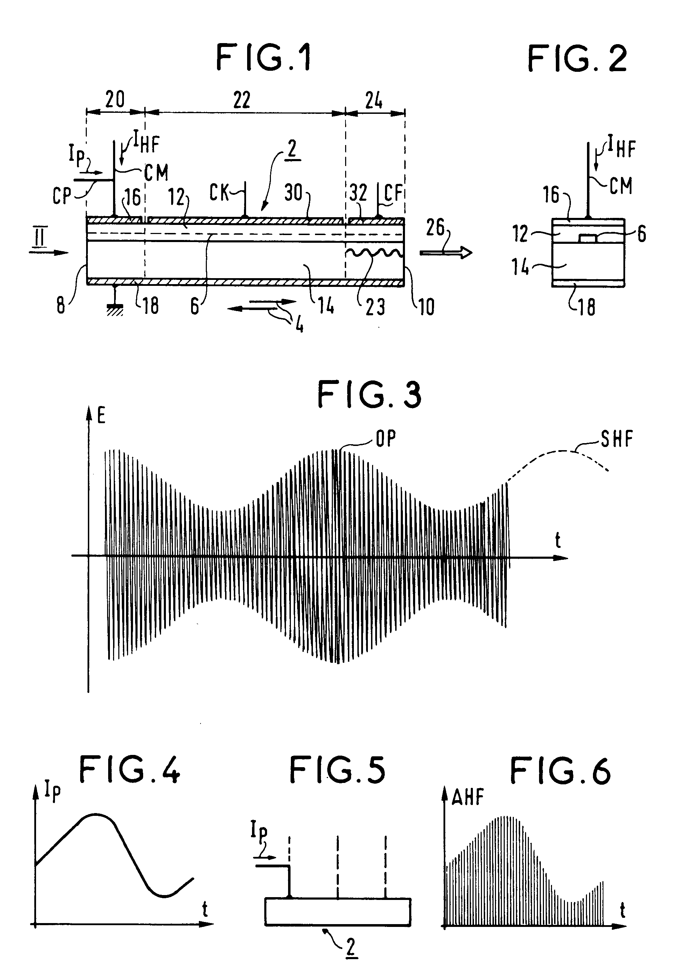

Sur les figures 1 et 2, ladite plaquette semi-conductrice est représentée en 2 et constitue une diode laser dont la longueur est disposée selon une direction longitudinale représentée par une double flèche 4. Un canal de lumière longitudinal est représenté en 6. Les faces extrêmes 8 et 10 de cette plaquette constituent les réflecteurs aux extrémités de la cavité optique constituée par ce canal. Deux couches de types de conductivité opposés 12 et 14 sont formées au dessus et au dessous d'une section de gain de ce canal pour permettre à un courant de polarisation de réaliser une inversion de population dans cette section. La structure interne de la diode constituée par la plaquette est en fait plus complexe, conformément aux dispositions connues pour la réalisation des diodes laser à semi-conducteurs.

Des moyens d'injection d'amplification et de modulation sont représentés par deux conducteurs CP et CM. Ils réalisent l'injection des courants de polarisation $I_p$ et de modulation $I_{HF}$ par l'intermédiaire d'une électrode localisée 16 et d'une électrode générale 18 pouvant être mise à la masse.

La section de gain 20 s'étend en regard de l'électrode 16. La section de filtrage est représentée en 24, le filtre additionnel étant représenté en 23. La section intermédiaire restante 22 constitue, avec cette section de filtrage, la section guide précédemment mentionnée.

L'onde de sortie est représentée par une flèche 26. Conformément à la figure 3 elle est constituée par une onde porteuse à fréquence optique OP modulée en amplitude par un signal hyperfréquence SHF, le temps t étant porté en abscisses et le champ électrique E en ordonnées.

Le composant ainsi réalisé constitue un convertisseur et/ou un amplificateur hyperfréquence car il fournit en sortie un signal hyperfréquence optique de puissance comparable ou supérieure à celle du courant de modulation électrique $I_{HE}$ qu'il reçoit en entrée à la même fréquence.

Conformément à une disposition parfois préférée selon l'invention le moyen d'injection d'amplification CP permet de commander à basse fréquence le courant de polarisation Ip, de manière à permettre de moduler à basse fréquence l'onde de sortie portant le signal hyperfréquence de sortie AHF. On constitue ainsi un modulateur d'amplitude pour cette onde de sortie et pour ce signal hyperfréquence.

Le composant utilisé pour cela est celui qui a été précédemment décrit sauf que le courant de polarisation IP varie comme indiqué sur la figure 4. Ce composant est symbolisé sur la figure 5, le signal hyperfréquence de sortie étant représenté en AHF sur la figure 6.

Sur la figure 5 comme sur celles des figures suivantes qui symbolisent des composants selon l'invention, des traits forts représentent les conducteurs par lesquels est amené un courant de commande. Un tel courant traverse l'une des trois sections telles que 20, 22, 24 au besoin par l'intermédiaire de l'une des électrodes supplémentaires 30 et 32 qui sont disposées sur les sections intermédiaire 22 et de filtrage 24 et qui portent des conducteurs CK et CF, respectivement.

La variation du courant de polarisation Ip ne provoque pas seulement une variation du gain. Elle provoque aussi une variation de l'indice de réfraction et donc de la longueur optique de al section de gain. C'est pourquoi la source peut comporte en outre un moyen de compensation de variation de longueur optique pour injecter un courant de compensation de longueur $I_K$ dans une section de modulation de phase 22, et pour faire varier ce courant de compensation en même temps que ledit courant de polarisation de manière à éviter une dérive de ladite fréquence intermode $f_i$. Un tel moyen de compensation est inutile si le but recherché est de faire varier la phase du signal hyperfréquence de sortie.

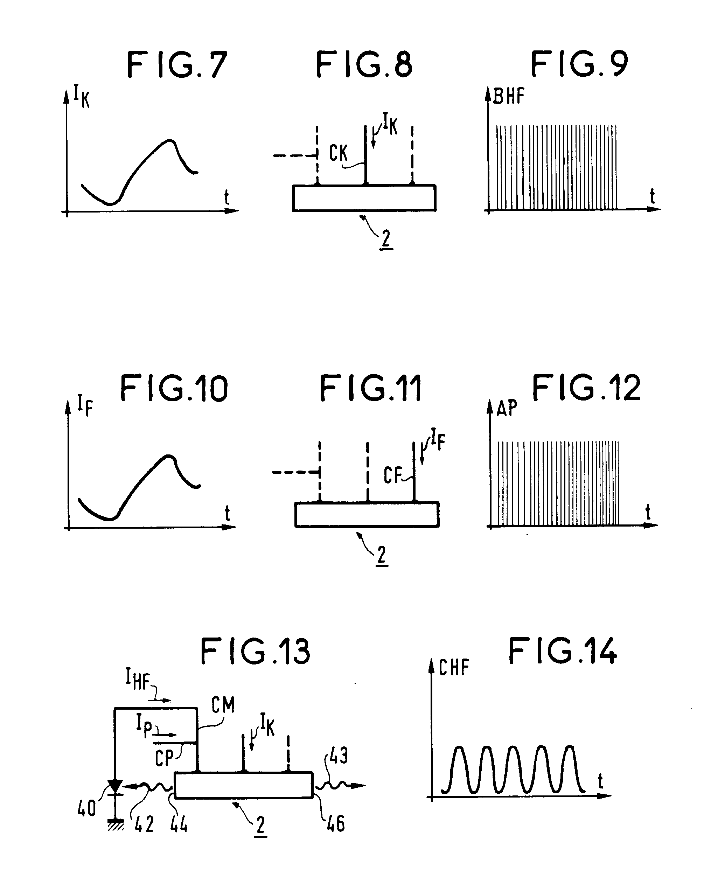

Conformément à une autre disposition parfois préférée illustrée par les figures 7 et 8 la source comporte en outre un moyen de modulation de phase recevant un signal de modulation de phase à basse fréquence ($I_K$) et commandant de manière correspondante la longueur de cavité L de manière à moduler la phase d'un signal hyperfréquence de sortie BHF représenté de manière très symbolique à la figure 9. Conformément à une autre disposition préférée ce moyen de modulation de phase comporte :

- une section de modulation de phase (constituée par la section intermédiaire 22) s'étendant sur au moins une fraction de ladite longueur de cavité, l'indice de réfraction dans ledit canal de guidage 6 dans cette section étant sensible à la densité de porteurs de charge,

- et un moyen d'injection de modulation de phase (constitué par le conducteur CK) pour injecter un courant électrique de modulation de phase $I_K$ à travers ce canal dans cette section de manière à y commander la densité de porteurs de charge, ce courant constituant ledit signal de modulation de phase.

On peut cependant noter que la longueur de la section de modulation de phase peut aussi être accordée par l'effet électro-optique, qui est plus rapide que la commande par injection de porteurs.

Une autre disposition parfois préférée est illustrée par les figures 10 et 11. Elle est applicable lorsque le filtre additionnel 23 est un réflecteur de Bragg distribué occupant la section de filtrage 22 à une extrémité de la cavité optique 6, 8, 10, et l'indice de réfraction dans le canal de guidage 6 dans cette section est sensible à la densité des porteurs de charge.

Selon cette disposition, la source comporte un moyen d'injection de modulation de fréquence (constitué par le conducteur CF) pour injecter un courant de modulation de fréquence $I_F$ à travers ce canal dans cette section de manière à y commander la densité de porteurs de charge pour moduler ainsi la fréquence de l'onde porteuse AP représenté de manière très symbolique à la figure 12.

Conformément à une autre disposition parfois préférée illustrée par les figures 13 et 14, la source comporte en outre :

- un photodétecteur 40 pour recevoir une onde de sortie et pour fournir en réponse un courant de détection représentatif du signal hyperfréquence de sortie CHF porté par cette onde,
- et un moyen de liaison (constitué par le conducteur CM qui peut être muni d'un amplificateur non représenté) pour engendrer le courant de modulation $I_{HF}$ à partir de ce courant de détection, de manière que cette source constitue un oscillateur hyperfréquence.

Dans l'exemple représenté deux ondes optiques de sortie sortent en même temps de la source par deux réflecteurs 44 et 46 qui remplacent les réflecteurs 8 et 10, l'une 42 vers le photodétecteur 40 qui est par exemple une diode photosensible, l'autre 43 pour constituer une onde de sortie de l'oscillateur hyperfréquence. La fréquence de ce dernier peut être commandée par un courant de modulation de fréquence qui est appliqué et agit comme le courant de modulation de phase précédemment mentionné. Le courant de modulation est constitué par le courant de détection, après amplification et/ou filtrage et/ou correction de phase éventuels.

**Revendications**

1. Source laser à semi-conducteur modulée à fréquence élevée comportant :
   - une plaquette monolithique (2) ayant deux faces extrêmes (8, 10) opposées, cette plaquette étant constituée d'un matériau semi-conducteur à dopage différencié dont l'indice de réfraction est localement diminué pour guider des ondes lumineuse sur la longueur d'un canal de lumière (6) s'étendant de l'une à l'autre des deux dites faces extrêmes,
   - un moyen d'injection d'amplification (CP, 12, 14)) pour injecter dans ladite plaquette un courant de polarisation unidirectionnel ($I_p$) réalisant une inversion de population dans ledit canal de lumière de manière à y amplifier desdites ondes lumineuses, le gain représentatif de l'amplification éventuelle d'une onde n'étant positif que si la fréquence de cette onde est située dans un domaine spectral de gain qui présente une largeur spectrale de gain,
   - deux réflecteurs (8, 10) pour constituer entre eux une cavité optique incluant ledit canal de lumière et présentant une longueur optique de cavité L, de sorte que cette cavité est résonnante selon une succession de modes pour des ondes lumineuses présentant une succession correspondante de fréquences propres, ces fréquences étant séparées par des intervalles égaux à une fréquence intermode

$$f_i = c/2L,$$

c étant la vitesse de la lumière, de manière que cette cavité constitue un oscillateur laser pouvant produire des ondes lumineuses à des fréquences proches de celles desdites fréquences propres qui sont situées dans ledit domaine spectral de gain, et qu'un couplage de modes soit possible entre les ondes produites,
   - et un moyen d'injection de modulation (CM) pour injecter dans ladite plaquette un courant de modulation alternatif ($I_{HF}$) présentant une fréquence de modulation ($f_m$) et traversant lui aussi ledit canal de lumière (6) pour y faire apparaître une composante de gain alternative, cette fréquence de modulation étant proche de ladite fréquence intermode pour y imposer un dit couplage de modes grâce auquel ledit oscillateur produit lesdites ondes lumineuses sous la forme d'une onde porteuse modulée (OP), au moins une composante de modulation de cette onde constituant un signal de modulation de sortie présentant ladite fréquence de modulation,
   - cette source étant caractérisée par le fait que ladite plaquette porte lesdits réflecteurs (8, 10) sur ses dites faces extrêmes de manière que ladite longueur optique de cavité L soit limitée par la longueur dudit canal de lumière pour situer ladite fréquence intermode ($f_i$) et par conséquent aussi ladite fréquence de modulation ($f_m$) dans le domaine des hyperfréquences, ledit signal de modulation constituant un signal hyperfréquence de sortie (SHF),
   - cette plaquette comportant en outre un moyen de limitation de dispersion (20, 22, 23, 24) disposé dans ladite cavité optique pour limiter la dispersion des temps de propagation de groupe desdites ondes lumineuses dans cette cavité,
   - et un filtre additionel (23) inclus dans ladite cavité optique (6, 8, 10) pour que ledit oscillateur laser ne puisse produire lesdites ondes lumineuses qu'à l'intérieur d'un domaine spectral de filtrage présentant une largeur de filtrage inférieure à la moitié de ladite largeur spectrale de gain, tout en étant supérieure à ladite fréquence intermode, de manière à éviter des instabilités des fréquences desdites ondes produites par ledit oscillateur laser,

- et ladite modulation de gain étant réalisée seulement dans une section de la longueur dudit canal de lumière, cette section étant une section de modulation de gain (20) et s'étendant sur une fraction minoritaire de cette longueur à une extrémité de celle-ci, de manière à imposer une phase prédéterminée audit signal hyperfréquence de sortie par rapport audit courant de modulation.

2. Source selon la revendication 1, caractérisée par le fait que ledit moyen d'injection d'amplification (CP, 12, 14) limite ladite inversion de population et ladite amplification des ondes lumineuses à une section de gain (20) dudit canal de lumière, cette section constituant en même temps ladite section de modulation de gain et sa longueur optique occupant une fraction inférieure au quart de ladite longueur optique de cavité (L), la fraction restante de la longueur de ce canal constituant une section guide (22, 24).

3. Source selon la revendication 1, caractérisée par le fait que ladite largeur de filtrage est comprise entre 2 fois et 100 fois ladite fréquence intermode ($f_i$) de manière que ledit couplage de modes se réalise sur plusieurs modes longitudinaux.

4. Source selon la revendication 1, dans laquelle ledit filtre additionnel (23) est un réflecteur de Bragg distribué occupant une section de filtrage (24) à une extrémité de ladite cavité optique (6, 8, 10).

5. Source selon la revendication 1, caractérisée par le fait que ledit canal de lumière (6) comporte des sections qui se succèdant selon sa longueur et qui présentent des valeurs de dispersion de signes opposés, ces valeurs étant représentatives de la dispersion de la vitesse de propagation de groupe desdites ondes lumineuses dans ces sections, respectivement, de manière que l'association de ces sections réalise une compensation de dispersions pour constituer ledit moyen de limitation de dispersion.

6. Source selon la revendication 2, caractérisée par le fait que ledit domaine spectral de filtrage est choisi pour coincider avec un domaine de fréquences dans lequel un paramètre de dispersion présente une valeur négative dans ladite section de gain alors qu'il présente une valeur positive dans ladite section guide (22, 24), cette valeur négative étant supérieure en valeur absolue à trois fois cette valeur positive, ce paramètre étant la dérivée seconde ($d^2n/d\ lambda^2$) de l'indice de réfraction (n) dans ledit canal de lumière par rapport à la longueur d'onde (lambda) desdites ondes lumineuses, de manière à réaliser une compensation de dispersion pour constituer ledit moyen de limitation de dispersion.

7. Source selon l'une quelconque des revendications précédentes dans laquelle l'un (10) au moins des deux dits réflecteurs est semi transparent pour laisser sortir une onde de sortie (26) constituée par ladite onde porteuse (OP) modulée par ledit signal hyperfréquence de sortie (SHF).

8. Source selon la revendication 7, caractérisée par le fait que ledit moyen d'injection d'amplification (CP) permet de commander à basse fréquence ledit courant de polarisation (Ip), de manière à permettre de moduler en amplitude à basse fréquence ladite onde de sortie portant ledit signal hyperfréquence de sortie (AHF), cette source comportant en outre un moyen de compensation de variation de longueur optique pour injecter un courant de compensation de longueur ($I_K$) dans une section de modulation de phase (22), et pour faire varier ce courant de compensation en même temps que ledit courant de polarisation de manière à éviter une dérive de ladite fréquence intermode ($f_i$).

9. Source selon la revendication 7, caractérisée par le fait que ledit moyen d'injection d'amplification (CP) permet de faire varier l'intensité dudit courant de polarisation ($I_p$) de manière à faire varier ladite fréquence intermode pour faire varier la phase dudit signal hyperfréquence de sortie, cette variation s'accompagnant d'une variation de l'amplitude de ladite onde de sortie portant un signal.

10. Source selon la revendication 7, caractérisée par le fait qu'elle comporte en outre un moyen de modulation de phase (CK) recevant un signal de modulation de phase à basse fréquence ($I_K$) et commandant de manière correspondante ladite longueur optique de cavité L de manière à moduler la phase dudit signal hyperfréquence de sortie (BHF).

**11.** Source selon la revendication 10, caractérisée par le fait que ledit moyen de modulation de phase comporte :

- une section de modulation de phase (22) s'étendant sur au moins une fraction de la longueur dudit canal de lumière (6) l'indice de réfraction dans ce canal dans cette section étant sensible à la densité de porteurs de charge,
- et un moyen d'injection de modulation de phase (CK) pour injecter un courant électrique de modulation de phase ($I_K$) à travers ce canal dans cette section de manière à y commander la densité de porteurs de charge, ce courant constituant ledit signal de modulation de phase.

**12.** Source selon la revendication 7, caractérisée par le fait que ledit filtre additionnel (23) est un réflecteur de Bragg distribué occupant une section de filtrage (24) à une extrémité dudit canal de lumière (6) l'indice de réfraction dans ce canal dans cette section étant sensible à la densité des porteurs de charge,

- cette source comportant en outre un moyen d'injection de modulation de fréquence (CF) pour injecter un courant de modulation de fréquence ($I_F$) à travers ce canal dans cette section de manière à y commander la densité de porteurs de charge pour moduler ainsi la fréquence optique de ladite onde porteuse (AP).

**13.** Source selon la revendication 7, caractérisée par le fait qu'elle comporte en outre :

- un photodétecteur (40) pour recevoir une dite onde de sortie et pour fournir en réponse un courant de détection ($I_{HF}$) représentatif dudit signal hyperfréquence de sortie (CHF) porté par cette onde,
- et un moyen de liaison (CM) pour engendrer ledit courant de modulation à partir de ce courant de détection, de manière que cette source constitue un oscillateur hyperfréquence.

## Claims

**1.** A semiconductor laser source modulated at high frequency, comprising:

- a monolithic plate (2) having two opposite end faces (8, 10), said plate being made of a semiconductor material with different doping and having a refractive index including a local low in order to guide light waves along the length of a light channel (6) extending between the two said end faces;
- amplification injection means (CP, 12, 14) for injecting DC bias current ($I_p$) into said plate to give rise to population inversion in said light channel so as to amplify said light waves therein, the gain representative of the possible amplification of a wave being positive only if the frequency of said wave lies in a gain spectrum range having a gain spectrum width;
- two reflectors (8, 10) together constituting an optical cavity including said light channel and having an optical cavity length L such that said cavity is resonant in a succession of modes for light waves having a corresponding succession of resonant frequencies, said frequencies being separated at intervals equal to an intermode frequency

$$f_i = c/2L$$

where c is the speed of light, in such a manner that such cavity constitutes a laser oscillator capable of producing light waves at frequencies close to those of said resonant frequencies which are situated in said gain spectrum range, and such that mode coupling is possible between the resulting waves; and
- modulation injection means (CM) for injecting an AC modulation current ($I_{HF}$) into said plate, said current having a modulation frequency ($f_m$) and likewise passing through said light channel (6) in order to cause an alternating gain component to appear therein, said modulation frequency being close to said intermode frequency in order to impose a mode coupling thereto whereby said oscillator produces said light waves in the form of a modulated carrier wave (OP), with at least one modulation component of said wave constituting an output modulation signal having said modulation frequency;
- said source being characterized by the facts that said plate carries said reflectors (8, 10) on its said end faces in such a manner that the optical length of the cavity L is limited by the length of said light channel situate said intermode frequency ($f_i$) and consequently also to limit said modulation frequency ($f_m$) in the microwave frequency range, said modulation signal constituting an output microwave frequency signal (SHF);

- said plate also includes dispersion limitation means (20, 22, 23, 24) disposed in said optical cavity to limit the group propagation time dispersion of said light waves in said cavity; and
- an additional filter (23) is included in said optical cavity (6, 8, 10) so that said laser oscillator can produce said light waves only within a filtering spectrum range having a filtering width which is less than half said gain spectrum width while still being greater then said intermode frequency, thereby avoiding frequency instabilities in said waves produced by said laser oscillator; and
- said gain modulation is performed solely in a section of the length of said light channel, said section constituting a gain modulation section (20) and extending over a minority fraction of said length at one end thereof, in such a manner as to impose a predetermined phase to said output microwave frequency signal relative to said modulation current.

2. A source according to claim 1, characterized by the fact that said amplification injection means (CP, 12, 14) limit said population inversion and said amplification of light waves to a gain section (20) of said light channel, said section simultaneously constituting said gain modulation section and its optical length occupying a fraction which is less than one fourth of said optical length of the cavity (L), the remaining fraction of the length of said channel constituting a wave guide section (22, 24).

3. A source according to claim 1, characterized by the fact that said filtering width lies between twice and 100 times said intermode frequency $(f_i)$ such that said mode coupling takes place over a plurality of longitudinal modes.

4. A source according to claim 1, in which said additional filter (23) is a distributed Bragg reflector occupying a filtering section (24) at one end of said optical cavity (6, 8, 10).

5. A source according to claim 1, characterized by the fact that said light channel (6) includes sections which follow one another lengthwise and which have dispersion values of opposite sign, said values being representative of the group propagation velocity dispersion of said light waves in said respective ones of said sections such that the association of said sections compensates the dispersions in order to constitute said dispersion limitation means.

6. A source according to claim 2, characterized by the fact that said filtering spectrum range is selected to coincide with a frequency range in which a dispersion parameter has a negative value in said gain section whereas it has a positive value in said waveguide section (22, 24), the absolute value of said negative value being greater than three times said positive value, said parameter being the second derivative $(d^2n/d.lambda^2)$ of the refractive index (n) in said light channel relative to the wavelength (lambda) of said light waves, thereby compensating the dispersion to constitute said dispersion limitation means.

7. A source according to any preceding claim in which at least one (10) of said two reflectors is semitransparent in order to allow an output wave (26) to leave, which is constituted by said carrier wave (OP) and modulated by said output microwave frequency signal (SHF).

8. A source according to claim 7, characterized by the fact that said amplification injection means (CP) provides low frequency control of said bias current (Ip), thereby enabling said output wave carrying said output microwave frequency signal (AHF) to be amplitude modulated at low frequency, said source also including means for compensating optical length variation in order to inject a length compensating current $(I_K)$ into a phase modulation section (22), and in order to vary said compensation current simultaneously with said bias current so as to prevent said intermode frequency $(f_i)$ drifting.

9. A source according to claim 7, characterized by the fact that said amplification injection means (CP) serves to vary said bias current (Ip) in such a manner as to vary said intermode frequency so as to vary the phase of said output microwave frequency signal, said variation being accompanied by variation in the amplitude of said signal-carrying output wave.

10. A source according to claim 7, characterized by the fact that it further includes phase modulation means (CK) receiving a low frequency phase modulation signal $(I_K)$ and controlling said cavity optical length (L) in corresponding manner so as to modulate the phase of said output microwave frequency signal (BHF).

11. A source according to claim 10, characterized by the fact that said phase modulation means comprises:

- a phase modulation section (22) extending over at least a fraction of the length of said light channel (6) with the refractive index in said channel in said section being sensitive to the charge carrier density; and
- phase modulation injection means (CK) for injecting a phase modulation electrical current ($I_K$) through said channel in said section in such a manner as to control the charge carrier density therein, said current constituting said phase modulation signal.

12. A source according to claim 7, characterized by the fact that said additional filter (23) is a distributed Bragg refractor occupying a filtering section (24) at one end of said light channel (6), the refractive index in said channel in said section being sensitive to the charge carrier density; and
    - said source further including frequency modulation injection means (CF) for injecting a frequency modulation current ($I_F$) through said channel in said section in such a manner as to control the charge carrier density therein, thereby modulating the optical frequency of said carrier wave (AP).

13. A source according to claim 7, characterized by the fact that it further includes:
    - a photodetector (40) for receiving said output wave and for responding by providing a detection current ($I_{HF}$) representative of said output microwave frequency signal (CHF) carried by said wave; and
    - link means (CM) for generating said modulation current from said detection current, in such a manner that said source constitutes a microwave frequency oscillator.

**Patentansprüche**

1. Hochfrequenzmodulierte Halbleiterlaserquelle, die aufweist:
    - ein monolithisches Plättchen (2) mit zwei einander gegenüberliegenden Endflächen (8, 10), das aus einem differenziert dotierten Halbleitermaterial besteht, dessen Brechungsindex örtlich verringert wird, um Lichtwellen entlang eines Lichtkanals (6) zu führen, der sich von dem einen zum anderen Ende der beiden Endflächen erstreckt,

- eine Verstärkungseinspeiseeinrichtung (CP, 12, 14), um einen Vorspannungsgleichstrom ($I_p$) in das genannte Plättchen einzuspeisen, der im Lichtkanal eine Populationsumkehr herbeiführt, derart, daß die Lichtwellen dort verstärkt werden, wobei die die mögliche Verstärkung einer Welle darstellende Verstärkung nur dann positiv ist, wenn die Frequenz dieser Welle in einem Verstärkungsspektralbereich liegt, der eine Verstärkungsspektralbreite besitzt,
- zwei Reflektoren (8, 10) zur Bildung eines optischen Hohlraumes zwischen diesen, der den Lichtkanal einschließt und eine optische Hohlraumlänge L besitzt, derart, daß der Hohlraum gemäß einer Modenfolge bei Lichtwellen in Resonanz geht, die eine entsprechende Folge von Eigenfrequenzen besitzen, und diese Frequenzen voneinander durch gleiche Intervalle entsprechend einer Zwischenmodenfrequenz $f_i$ = c/sL getrennt sind, wobei c die Lichtgeschwindigkeit ist, derart, daß der Hohlraum einen Laseroszillator bildet, der Lichtwellen mit Frequenzen in der Nähe der genannten Eigenfrequenzen erzeugen kann, die in dem Verstärkungsspektralbereich liegen, und daß eine Modenkopplung zwischen den erzeugten Wellen möglich ist,
- eine Modulationseinspeiseeinrichtung (CM), um in das Plättchen einen Modulationswechselstrom ($I_{HF}$) einzuspeisen, der eine Modulationsfrequenz ($f_m$) besitzt und auch den Lichtkanal (6) durchquert, um darin eine Verstärkungswechselkomponente entstehen zu lassen, wobei die Modulationsfrequenz in der Nähe der Zwischenmodenfrequenz liegt, um so eine Modenkopplung zu erzwingen, aus der der Oszillator die Lichtwellen in Form einer modulierten Trägerwelle (OP) erzeugt, wobei mindestens eine Modulationskomponente dieser Welle ein Ausgangsmodulationssignal ergibt, das die Modulationsfrequenz aufweist;
- wobei die Laserquelle dadurch gekennzeichnet ist, daß das Plättchen an seinen Endseiten die Reflektoren (8, 10) trägt, derart, daß die optische Hohlraumlänge L durch die Länge des Lichtkanals begrenzt ist, um die Intermodenfrequenz ($f_i$) und dementsprechend auch die Modulationsfrequenz ($f_m$) in den Mikrowellenbereich zu bringen, wobei das Modulationssignal ein Ausgangsmikrowellensignal (SHF) ist,

- daß das Plättchen weiter eine Dispersionbegrenzungseinrichtung (20, 22, 23, 24) aufweist, die in dem optischen Hohlraum angeordnet ist, um die Streuung der Gruppenlaufzeiten der Lichtquellen im Hohlraum zu begrenzen,
- und daß ein zusätzliches Filter (23) im optischen Hohlraum (6, 8, 10) enthalten ist, so daß der Laseroszillator die Lichtwellen nur innerhalb eines spektralen Filterbereiches mit einer Filterbreite erzeugen kann, die kleiner als die Hälfte der Verstärkungsspektralbreite, aber größer als die Intermodenfrequenz ist, so daß Instabilitäten der Frequenzen der vom Laseroszillator erzeugten Wellen vermieden werden,
- wobei die Verstärkungsmodulation nur in einem Abschnitt der Länge des Lichtkanals erfolgt und dieser Abschnitt ein Verstärkungsmodulationsabschnitt (20) ist, der sich über einen kleineren Teil dieser Länge, an einem Ende derselben, erstreckt, derart, daß dem Ausgangsmikrowellensignal eine vorbestimmte Phase relativ zum Modulationsstrom eingeprägt wird.

2. Quelle nach Anspruch 1, dadurch gekennzeichnet, daß die Verstärkungseinspeiseeinrichtung (CP, 12, 14) die Populationsinversion und die Verstärkung der Lichtwellen auf einen Verstärkungsabschnitt (20) des Lichtkanals beschränkt, wobei dieser Abschnitt gleichzeitig den Verstärkungsmodulationsabschnitt bildet und seine optische Länge kleiner als ein Viertel der optischen Hohlraumlänge (L) ist, und wobei der restliche Teil der Länge dieses Kanals einen Wellenleiterabschnitt (12, 24) bildet.

3. Quelle nach Anspruch 1, dadurch gekennzeichnet, daß die Filterbreite zwischen dem 2- und 100-fachen der Intermodenfrequenz ($f_i$) liegt, derart, daß die Modenkopplung über mehrere Längsmoden erfolgt.

4. Quelle nach Anspruch 1, bei der das Zusatzfilter (23) ein verteilter Bragg-Reflektor ist, der an einem Ende des optischen Hohlraumes (6, 8, 10) einen Filterabschnitt (24) einnimmt.

5. Quelle nach Anspruch 1, dadurch gekennzeichnet, daß der Lichtkanal (6) Abschnitte umfaßt, die in seiner Längsrichtung aufeinander folgen und Dispersionswerte mit entgegengesetzten Vorzeichen besitzen, wobei diese Werte die Streuung der Gruppenfortpflanzungsgeschwindigkeit der Lichtwellen in diesen Abschnitten darstellen, derart, daß die Kombination der Abschnitte eine Dispersionskompensation herbeiführt und die Dispersionsbegrenzungsanordnung bildet.

6. Quelle nach Anspruch 2, dadurch gekennzeichnet, daß der spektrale Filterbereich so gewählt ist, daß er mit demjenigen Frequenzbereich übereinstimmt, bei dem ein Dispersionsparameter in dem Verstärkungsabschnitt einen negativen Wert besitzt, während er in dem Wellenleiterabschnitt (22, 24) einen positiven Wert besitzt, wobei der negative Wert absolut größer als das Dreifache des positiven Wertes ist, und wobei dieser Parameter die zweite Ableitung ($d^2n/d$ lambda$^2$) des Brechungsindex (n) in dem Lichtkanal zur Wellenlänge (lambda) der Lichtwellen ist, so daß eine Dispersionskompensation zur Bildung der genannten Dispersionsbegrenzungsanordnung geschaffen wird.

7. Quelle nach einem beliebigen vorhergehenden Anspruch, bei der mindestens einer (10) der beiden Reflektoren halbdurchlässig ist, um eine Ausgangswelle (26) austreten zu lassen, die aus der Trägerwelle (OP) besteht, welche durch das Ausgangsmikrowellensignal (SHF) moduliert wird.

8. Quelle nach Anspruch 7, dadurch gekennzeichnet, daß es die Verstärkungseinspeiseeinrichtung (CP) den Vorspannstrom (Ip) niederfrequent so steuern kann, daß die das Ausgangsmikrowellensignal (AHF) tragende Ausgangswelle bei niedriger Frequenz amplitudenmoduliert werden kann, wobei die Quelle weiter eine Einrichtung zum Kompensieren der optischen Längenänderung aufweist, um in einen Phasenmodulationsabschnitt (22) einen Längenkompensationsstrom ($I_K$) einzuspeisen und um diesen Kompensationsstrom gleichzeitig mit dem Vorspannstrom zu ändern, so daß ein Abdriften der Zwischenmodenfrequenz ($f_i$) vermieden wird.

9. Quelle nach Anspruch 7, dadurch gekennzeichnet, daß die Verstärkungseinspeiseeinrichtung (CP) die Stärke des Vorspannstromes ($I_p$) so ändern kann, daß die Intermodenfrequenz geändert wird, um die Phase des Ausgangsmikrowellensignals zu ändern, wobei diese Änderung von einer Amplitudenänderung der ein Signal tragenden Ausgangswelle begleitet wird.

10. Quelle nach Anspruch 7, dadurch gekennzeichnet, daß sie weiter eine Phasenmodulationseinrichtung (CK) aufweist, die ein Phasenmodulationssignal ($I_K$) mit niedriger Frequenz empfängt und in entsprechender Weise die optische Hohlraumlänge (L) steuert, derart, daß die Phase des Ausgangsmikrowellensignals (BHF) moduliert wird.

11. Quelle nach Anspruch 10, dadurch gekennzeichnet, daß die Phasenmodulationsanordnung aufweist:

- einen Phasenmodulationsabschnitt (22), der sich mindestens über einen Teil der Länge des Lichtkanals (6) erstreckt, wobei der Brechungsindex in diesem Kanal innerhalb dieses Abschnittes auf die Ladungsträgerdichte anspricht, und
- eine Phasenmodulationseinspeiseeinrichtung (CK) zum Einspeisen eines elektrischen Phasenmodulationsstromes ($I_K$) durch diesen Kanal in diesen Abschnitt, derart, daß darin die Ladungsträgerdichte gesteuert wird, wobei dieser Strom das genannte Phasenmodulationssignal bildet.

12. Quelle nach Anspruch 7, dadurch gekennzeichnet, daß das Zusatzfilter (23) ein verteilter Bragg-Reflektor ist, der an einem Ende des Lichtkanals (6) einen Filterabschnitt (24) einnimmt, wobei der Brechungsindex in diesem Kanal innerhalb des Abschnittes auf die Ladungsträgerdichte anspricht, und

- wobei die Quelle weiter eine Frequenzmodulationseinspeiseeinrichtung (CF) aufweist, um durch diesen Kanal einen Frequenzmodulationsstrom ($I_F$) in diesen Abschnitt einzuspeisen, so daß dort die Ladungsträgerdichte gesteuert und so die Lichtfrequenz der Trägerwelle (AP) moduliert wird.

13. Quelle nach Anspruch 7, dadurch gekennzeichnet, daß sie weiter aufweist:

- einen Photodetektor (40) zum Empfangen einer Ausgangswelle und zum Liefern eines Erfassungsstromes ($I_{HF}$), der das von der Welle geführte Ausgangsmikrowellensignal (CHF) darstellt, und
- eine Begrenzungseinrichtung (CM) zum Erzeugen des Modulationsstromes aus dem Erfassungsstrom, derart, daß die Quelle einen Mikrowellenoszillator bildet.

EP 0 358 144 B1

# FIG.1

# FIG.2

# FIG.3

# FIG.4

# FIG.5

# FIG.6

16

# FIG.7

# FIG.8

# FIG.9

# FIG.10

# FIG.11

# FIG.12

# FIG.13

# FIG.14